(19) Europäisches Patentamt

European Patent Office

Office européen des brevets

(11) **EP 1 278 248 A1**

(12) **EUROPEAN PATENT APPLICATION**
published in accordance with Art. 158(3) EPC

(43) Date of publication:
**22.01.2003 Bulletin 2003/04**

(51) Int Cl.7: **H01L 31/04**, H01L 31/042, H01L 31/052, H01L 31/0328, H01L 31/0352

(21) Application number: **01929655.7**

(22) Date of filing: **27.04.2001**

(86) International application number:
**PCT/ES01/00167**

(87) International publication number:
**WO 01/084636 (08.11.2001 Gazette 2001/45)**

(84) Designated Contracting States:
**AT BE CH CY DE DK ES FI FR GB GR IE IT LI LU MC NL PT SE TR**

(30) Priority: **27.04.2000 ES 200001088**

(71) Applicant: **UNIVERSIDAD POLITECNICA DE MADRID 28040 Madrid (ES)**

(72) Inventor: **ALGORA DEL VALLE, C. Instituto de Energia Solar E-28040 Madrid (ES)**

(54) **HIGH EFFICIENCY PHOTOVOLTAIC CONVERTER FOR HIGH LIGHT INTENSITIES MANUFACTURED WITH OPTOELECTRONIC TECHNOLOGY**

(57)    The invention concerns photvoltaic converters that work under high intensity light and provide high efficiency. Said converters generate photovoltaic electricity at low costs, which is very interesting for the photovoltaic industry. They can be used in thermophotovoltaic systems and remote supply systems via optical fiber. The converter is characterized by the following features: a) its semiconductor layers are made of compunds III-V; b) photolithography is used to manufacture it and c) its size ranges from a few tenths to tens of square millimiters. Other optoelectronic techniques may be used for manufacturing such as wire welding, separation of the converters on one same wafer by sawing, point cutting and cleavage. Its design parameters are estimated by means of multivariable optimization. The situation in which the incident light has the shape of a cone and originates from a medium with any given refraction index is taken into account in the operating conditions.

Fig. 1

EP 1 278 248 A1

**Description**

A photovoltaic converter which transforms high intensity light into electricity with a high efficiency is described. Its manufacture is based on standard processes used in the optoelectronic industry. The reduced cost of the electricity stems from the use of high intensity light, and its high level of efficiency (defined as the fraction of electrical power produced by the converter with respect to the incident luminous power) in relation to the efficiencies usually obtained when the converter is operating under high intensity light, as well as the low cost of optoelectronic manufacture.

BACKGROUND OF THE INVENTION

One of the most promising strategies in the photovoltaic industry to achieve a reduction in the price of electricity is the use of concentration. Concentration is based on the use of optical elements which increase the intensity of the solar light falling on the solar cell (photovoltaic converter). Thus, the semiconductor material of the cell is substituted by the optical material, which is very much cheaper. There are other applications in which a photovoltaic converter transforms high intensity light. The most well known are: a) the transformation of monochromatic light emanating from a laser and channeled through an optical fiber, in which the intensity of the light is high, not because it has been concentrated by optical methods but through the elevated irradiance of the laser, and b) the conversion of infrared light (heat) into electricity, which is known as thermophotovoltaic conversion, in which the intensity of the radiation can be elevated according to the heat source. This is understood as high intensity which exceeds 100 mW/cm$^2$, which is the average level of solar radiation which reaches the Earth. Thus, and from a practical point of view, which established a clear difference, in this invention high intensities are understood as those greater than 1 W/cm$^2$ (10 times the average solar radiation).

Throughout this description and for reasons of simplicity light is understood as ultraviolet radiation, visible and infrared, in such a way that photovoltaic conversion also encompasses thermophotovoltaic conversion. A photovoltaic converter is understood as a semiconductor device that transforms light into electricity.

Of the different kinds of semiconductor materials, III-V compounds such as gallium arsenide, gallium antimonide, gallium aluminium arsenide, etc. are especially suitable for constructing high-efficiency photovoltaic converters. Many of them work efficiently with high-intensity light. Thus, at the present time, the highest efficiency in the world for silicon solar cells is 26.8% under a luminous intensity equivalent to 96 suns, while in the case of gallium arsenide it is 27.6% at 255 suns. As can be seen, although the efficiencies are similar, the luminous intensities at which they are obtained are very different, gallium arsenide being much higher.

However, this privileged situation enjoyed by photovoltaic converters based on III-V semiconductors is not reflected in the photovoltaic industry at the moment. In the first place, there is hardly any manufacturing of solar cells using III-V semiconductors due to the high cost compared to silicon, except in space applications where cost is not a main consideration in the decision-making process. In the second place, the use of high intensity light, which would reduce the cost, conflicts with the almost non-existence of photovoltaic converters which work efficiently under high luminous intensities. This non-existence is due mainly to: a) the series resistance of the converter when high photocurrents pass through it (produced under intensive light) which causes ohmic losses that deteriorate the overall efficiency, and b) the heat given out by the high-luminous incident power, and where it is not extracted efficiently. This can also deteriorate the efficiency of the converter, even causing its destruction.

Traditionally, manufacture has been based on an optimum design of the converters that considers reality in a partial way. On the one hand, the semiconductor structure was optimized with the objective of achieving maximum efficiency. On the other hand, the antireflection layers were optimized with the idea of minimizing the reflectance or maximizing the transmittance, and at the same time, the front metal grid was optimized with the aim of achieving minimum series resistance.

These three phases in the design, linked to a number of other phases in the manufacture of photovoltaic converters, have, up until now, been carried out independently, except for the use of some artificially imposed linking conditions, which have led to designs which, on occasions, are very far from optimal. There are numerous examples. Thus, for the design of a semiconductor structure it was essential for a certain intensity of light to enter the photovoltaic converter without knowing exactly the amount of light actually permitted to enter by the antireflection layers. In the design of the semiconductor structure the values of the specific contact resistances were not taken into account. Neither an optimum area nor size of the converter has been determined, nor has the case in which the light reaching the converter in the shape of a cone been analyzed as happens when the light is concentrated using optical elements.

Therefore, and given the potential offered by photovoltaic converters based on III-V semiconductors, it is clear that if a way were found to manufacture them cheaply and in such a way that they work efficiently under intense light, and overcoming the current problems both in the design and in the achievement these photovoltaic converters would be transformed into an attractive product and would therefore attract both industrial and commercial interest.

EXPLANATION OF THE INVENTION

Consequently, this invention includes the processes and procedures for obtaining photovoltaic converters, which work under intense light and having the following characteristics:

a) *Obtaining a high efficiency,* thanks to a design, which for the first time considers the entire converter, that is, as a whole made up of its semiconductor structure, its ohmic contacts, its shape, its metal grid and antireflection layers in relation to the other parameters instead of each one individually.

b) *Efficient heat extraction,* due to the reduced size of the converter proposed here (from several tenths of a square millimeter up to several square millimeters), calculating the optimum size for each luminous concentration and for the characteristics of the available manufacturing techniques.

c) *Reduced price,* thanks to the use of normal techniques used in the optoelectronic industry through which the reduction in costs is achieved, the use of devices based on III-V semiconductors such as light emitting diodes (LEDs), laser diodes, photodiodes, etc has become widespread. It is also an industry in constant evolution and in which new techniques are becoming more and more appreciated which can be used in the manufacture of the photovoltaic converters proposed here.

Although the solutions to the aforementioned problems (a, b and c) independently constitute something new, it is the use of the three together that produces excellent photovoltaic converters. Of course, the singular design that is presented determines converters that cannot be manufactured without the use of optoelectronic techniques. For its part, the degree of development of these techniques influences the optimum size of the converter and constantly feeds the design back, which is capable of adapting the optimum structure of the converter according to the external working conditions and of the available manufacturing techniques. Therefore, the optimum structure of the converter will be according to the external working conditions and of the available manufacturing techniques.

The expression "cone of light" is used in this patent simply to refer to the situation in which the luminous beam varies in size on its way to the converter. The exact final shape will depend, to a large extent, on the shape of the optical components. For example, if it is circular, the beam of light will be approximately cone shaped and if it is square, it will be a pyramid-shaped. In concentration applications, the optical components are bigger than the converter, but the situation can also be reversed, that is, the converter is bigger than the beam of light. Such is the case of laser light leaving an optical fiber of a few microns in diameter illuminating a converter of several square millimeters, for example. This is the usual situation in optical fiber based power-by-light systems. As a consequence, in this application these situations of concentration/deconcentration and the different shapes of the incident luminous beam on the converter are grouped together under the term "cone of light".

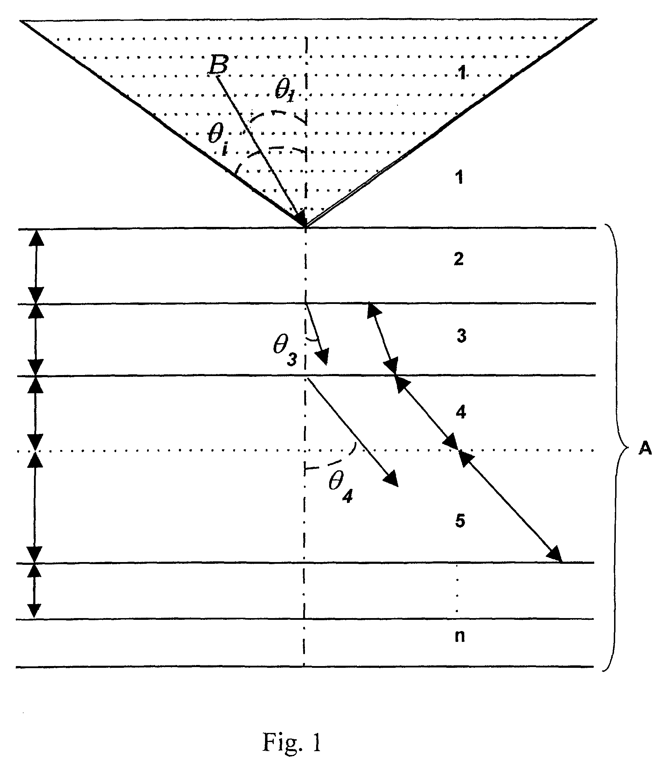

The density of the illumination current of a photovoltaic converter (see figure 1) receiving the light from a medium (1) with a given refraction index within a cone which forms an angle ($\theta_i$) with the normal is:

$$J_L(\theta_i) = \frac{q \int_0^{\theta_i} \int_{\lambda_{Light}}^{\lambda_{EG}} [1 - F_s(\theta_i)] N_{ph}(\lambda) T(\theta, \lambda) \, \text{sen} \, 2\theta \, QE(\theta, \lambda) \, d\theta \, d\lambda}{\text{sen}^2 \theta_i} \qquad [1]$$

in which the transmissivity, $T(\theta, \lambda)$ must be evaluated for the range of wavelengths which share the incident light ($\lambda_{Light}$) and the semiconductor bandgap ($\lambda_{EG}$). The rest of the parameters are the electron charge, $q$; the shadowing factor of the front metal grid which is optimum for a given angle, $F_s(\theta_i)$; the spectrum of the incident light, $N_{ph}(\lambda)$ and the internal quantum efficiency of the photovoltaic converter, $QE(\theta, \lambda)$, which is a function of numerous parameters of the semiconductor structure such as thicknesses, doping levels, lifetimes, absorption coefficients, etc. The equation [1] is valid for a conical cone of light, and isotropic in radiance. The expressions sin2θ and sin$^2\theta_i$ come from this situation. For other shapes, such as those previously referred to, and other angular distributions of incident luminous power, the expression of the equation [1] must be modified, with any expert understanding its geometric calculation. In any event, the conclusions obtained here for the cone shape are applicable to the rest of the situations.

As well as this change, the usual expression for the quantum efficiency must be slightly modified when the light reaches the converter (A) in the shape of a cone, since the light passing from the incident medium to the photovoltaic converter, experiences a change in direction (refraction). The angle of light formed with the normal in each semiconductor layer is governed by Snell's Law, so the given angle determines the path in which the light passes through each layer. Therefore, the light does not pass through the layers perpendicularly, but obliquely so that its path is greater. As a consequence, these paths, which we call optical thicknesses have to substitute the layer thicknesses in the expression of quantum efficiency.

Knowing the expression of $J_L(\theta_i)$ through the equation [1], the *J-V* characteristic (current density -voltage) of a photovoltaic converter can be expressed as

$$J(\theta_i) = J_L(\theta_i) - J_{01}(\theta_i)\left[\exp\frac{V(\theta_i) + J(\theta_i)r_s(\theta_i)}{V_T} - 1\right] - J_{02}(\theta_i)\left[\exp\frac{V(\theta_i) + J(\theta_i)r_s(\theta_i)}{2V_T} - 1\right] \qquad [2]$$

where $J_{01}(\theta_i)$ is the *kT*-recombination current density where *k* is the Boltzman constant, $J_{02}(\theta_i)$ is the *2kT*-recombination current density, $V_T$ is the thermal potential and $r_s(\theta_i)$ the series resistance. All of them depend on the angle formed by the cone of light with the normal. As well as this, $J_{01}(\theta_i)$ depends, among other things, on the thicknesses and doping levels of the semiconductor layers, inasmuch as $J_{02}(\theta_i)$ depends, among other things, on the recombination of the perimeter, which in turn, depends on the perimeter/area relationship of the photovoltaic converter.

The series resistance is made up of a number terms where several of them could be a function of the angle $\theta_i$. Basically, these can be expressed as:

$$r_S = r_{FC} + r_L + r_{BC} + r_V + r_G \qquad [3]$$

where $r_L$ is the lateral flow resistance of the current; $r_V$ is the vertical flow resistance of the current; $r_G$, is the contribution of the front metal grid; $r_{BC}$, is the contribution of the rear contact and $r_{FC}$, is the contribution of the front contact. Therefore, the series resistance, because of its different origins, depends on the shape of the converter (circular, square, rectangular, etc.), on the shape of the front metal grid, on the size of the device, on the thicknesses and doping levels of the semiconductor layers, on the conductivity of the metals and their thicknesses and the specific resistance of the contacts, etc.

With the help of equation [3], equation [2] can be solved in order to obtain the illumination characteristics *J* $(\theta_i)$-$V(\theta_i)$. From this, the efficiency for any cone of light can be calculated. In the case of perpendicular or tilted illumination, the calculations can be simplified considerably since there is no dependence on the angle $\theta_i$ (perpendicular illumination) or, if it does exist, it is not necessary to integrate them in the equation [1] for the said angle (oblique illumination). The model incorporates the general case in which the light (cone of light with the corresponding spectrum in each particular case) reaches the converter from a medium different from air (that is, with any refraction index). This possibility of calculating is especially important for photovoltaic converters which make up more complex systems and for which it is necessary for them to be encapsulated in epoxy or silicone rubber. Such is the case, for example, of photovoltaic concentration systems based on non-imaging optics in which the photovoltaic converter is assembled to an optical concentrator by means of silicone rubber, epoxy, resins or something similar, as happens in applications in which the light source is solar or heat.

The tremendous advantage of this model is that it can maximize the efficiency function by means of multidimensional calculation methods, so as to be able to determine the values of several design parameters of the converter (III-V compound semiconductor structure, ohmic contacts, geometry, metal grid y antireflection layers) which maximize the performance. This operation is known as multivariable optimization.

All of this calculation procedure can be incorporated into a computer program which carries out the enormous amount of necessary calculations in just a few seconds. Thus, assuming a given spectrum and luminous intensity as well as a working temperature, the optimum thickness and doping values of the semiconductor layers, thicknesses of antireflection layers, size of the converter, shape and shadowing factor of the front metal grid, etc. can be obtained. That is, given the external working conditions, the characteristics of the optimum photovoltaic converter can be determined.

Another added use is due to the adaptation of each specific manufacturing technology. In a photovoltaic converter there are parameters with optimum values (such as those previously mentioned). For example, the shadowing factor should be as small as possible from the point of view of maximizing the light that enters the converter but, at the same time, it is desirable for it to be as big as possible in order to diminish the series resistance. The optimum shadowing factor comes from this compromise. Additionally, there are other parameters whose best value is the maximum or minimum that can be achieved. For example, the specific contact resistance should be as small as possible. Equally, the conductivity of the metals should be as great as possible. Obviously, both the optimum values (resulting from the compromise) and the maximums and minimums are limited on many occasions by the technology available. Therefore, the technologically achievable values condition the rest of the converter structure. The design presented here allows these situations to be incorporated, thus making the industrial planning process possible. Consequently, for the determination of the optimum design it is necessary to know, in the first place, most of the characteristic parameters of the technology in order to later calculate the optimum values of the other parameters.

Thus, for example, the suitable procedure for determining the shadowing factor of the front metal grid needs, firstly, to know the specific resistance values of the contact, the conductivity of the metal and the finger width. This is obtained using a certain technology in order to later calculate optimum thicknesses and doping levels of the semiconductor layers, as well as the optimum shadowing factor of the grid. This process allows us to obtain more efficient converters than those currently being obtained using the process in use at the moment. This consists of determining directly the shadowing factor just by knowing the incident luminous intensity. In conclusion, the design advocated here allows us to determine the characteristics of the photovoltaic converter which achieves the highest efficiency for a certain technology and given external working conditions. Obviously, the model allows us to make additional refinements, such as the inclusion of series resistance in the busbar and the contact terminal, as well as the dark diode under the busbar. However, the results of the optimization are not seen to be modified significantly, so in the search for simplicity they have not been included in this description.

One of the most novel results of this optimum design is the size of the photovoltaic converters. It is in the order of square millimeters and even as small as less than one square millimeter, as in, for example, for light intensity higher than 1000 suns in the case of gallium arsenide (GaAs). Therefore, in order to quantify on the optimum size of the converters made from different III-V compounds and luminous intensities, it can be said that they range from tenths to tens of square millimeters. These such small sizes are completely different from those currently being manufactured in the photovoltaic industry (which are usually several square centimeters in size and even tens to hundreds of square centimeters). Therefore a reappraisal of the manufacturing process is necessary. Our answer to manufacturing solar cells using III-V semiconductors at a reduced size is to use techniques and processes of the microelectronic and optoelectronic industry because: a) our proposed converters are about a square millimeter in size which fits in well with the optoelectronic and microelectronic manufacturing guidelines and b) III-V semiconductors are well-known in optoelectronic and microelectronic industry, having given rise to reduced cost devices. These two characteristics are very different from those currently used in the photovoltaic industry.


A BRIEF EXPLANATION OF THE DRAWING

Figure 1 shows a section of a photovoltaic converter (A) which consists of several semiconductor layers (from 3 to n-1). The layer n is a substrate and can be as a III-V semiconductor or any other type of semiconductor such as germanium or silicon, or even a non-semiconductor substrate such as ceramic, glass or similar supports on which the semiconductor layers are stacked The upper part of the photovoltaic converter (A) is in contact with a medium (1) which has a given refractive index. The light arrives in the shape of a cone (shaded area) from an incident medium (1) to the photovoltaic converter (A). This cone forms an angle $\theta_i$ with the normal of the converter (A). The cone of light is modeled as a set of light beams of different wavelengths ($\lambda$) and each ray (B) forms an angle $\theta_1$ with the normal of the converter and carries a certain luminous power.

The light passes through the system of antireflection layers (2) in order to reach the photoactive semiconductor layers (3 to n-1). The ray given as an example (B) does not pass through the layers perpendicularly, but obliquely (due to refraction), in such a way that the path is longer (oblique arrows with just one point), forming an angle with the normal $\theta_3$, $\theta_4$, etc. in each layer. As a consequence, these paths that we call optical thicknesses (oblique arrows with two points), have to substitute the thicknesses of the layer (vertical arrows with two points) in the expression of quantum efficiency.

This situation is the same for all of the semiconductor layers in the converter made of a different material (as in 3 and 4) except in the case where two adjoining layers are made of the same material (as in 4 and 5) in which case there is no refraction. The process is complete when having passed through all of the layers the light reaches the substrate (n). For simplicity, neither the front nor rear metal contact have been drawn.


PRODUCTION METHOD

Consequently, one possible production method would consist of: a) the growth of a semiconductor structure based on III-V compounds on a substrate using technologies such as MOCVD, LPE or MBE, b) the deposition of the rear metal contact by means of evaporation and thermal treatment for the formation of the ohmic contact, c) the photolithographic process for the definition of the numerous photovoltaic converters on the same semiconductor wafer, as well as the shape of the frontal grid of each of them, d) the deposition of the front metal contact by means of evaporation, lift-off and thermal treatment for the formation of the ohmic contact e) the deposition of antireflection layers, f) the separation of converters on the same wafer by means of sawing, cutting with a diamond point, cleaving or other similar methods; a previous mesa etching is recommendable in order to reduce the damaging effects of cutting. Once the numerous photovoltaic converters are obtained from a wafer, each of them can be encapsulated by means of: g) fixing the converter by means of its rear contact to a support using epoxy or solder, and h) connection of the front contact through wire bonding, pick and place, flip-chip, multichip-module or something similar. Once encapsulated, the converter can be assembled to an optical concentrator by means of silicone rubber, epoxy, resins or something similar.

Any technique in which a motif or drawing is defined on the semiconductor surface so that a process can be carried out later, such as metalization, chemical etching, etc., is considered as photolithography in this patent. The photolithographic characteristic is the use of compounds sensitive to radiation of a certain wavelength, as occurs, for example, in optical lithography, x-rays, micro and nanolithography, etc.

As a consequence of the optimum design some processes which up until now have been necessary can be relaxed or even eliminated. For example, the electrolysis of the front grid (with which an increase in the thickness of fingers can be achieved, and, as a consequence the series resistance is reduced) can be eliminated. To counterbalance the electrolysis suppression, it is enough to evaporate a thickness of the front contact by a few tenths of a micron, or if necessary by a few microns for which some types of negative photoresists can be used. This will permit metal several microns thick to be achieved without rendering difficult lift-off.

Both the specific design and the manufacturing procedure described for solar and heat sources can be applied to both photovoltaic converters with just one p-n semiconductor junction (single junction) and those with several different semiconductor junctions (multijunction). These are usually called tandem converters or tandem cells. These structures are of great importance since they are seen as the future of photovoltaic converters, given that they are capable of achieving higher efficiencies than the single junction ones as they take better advantage of the incident light spectrum. They can also be applied to photovoltaic converters with a monolithic connection in series, such as those used in fiber optic based power-by-light systems, in order to increase the output voltage. Finally, this invention is also an application for obtaining thermophotovoltaic converters in which the semiconductor material from which it is made, and its design is adapted to the infrared spectrum coming from a heat source. Thermophotovoltaic converters can be either single junction or multijunction (just as in the case of solar, they achieves a better efficiency as they take better advantage of the infrared spectrum), and can have, or not, a monolithic connection in series.

Consequently, the photovoltaic converters described in this invention are of interest in three industrial fields: a) photovoltaic solar energy for which the spectrum comes from the sun, where the converters have to be assembled to optical concentrators which increase the luminous intensity of the sun so, if higher efficiencies and reduced costs are achieved, the final cost of the electrical energy produced will be comparable to that obtained from fossil fuels; b) the production of electrical energy from heat sources such as steel or aluminium foundries, glassworks, etc. Another wide market is opening up in individual applications, to which there is no conventional electricity supply, where there were stoves or other heat sources based on combustion from which electricity could be generated; and c) the conversion of channeled light by optical fiber and coming from a laser or another source of monochromatic light. These systems called optical fiber based power-by light by manage to send electrical energy to places where its supply is impeded by problems of galvanic isolation, sparks, etc. Examples are the powering of sensors and electronics in applications such as mines, high voltage grids, the chemical and petrochemical industries, nuclear power stations, airplanes, rockets, satellites, biomedicine, among others.

The previously set out regulations are susceptible to detail modifications while not altering its fundamental principle as, for example, the use of different types of substrate upon which to carry out the growth of the semiconductor structure. Thus the substrate can be a III-V semiconductor or any other type of semiconductor such as germanium or silicon, or even a non-semiconductor substrate such as ceramic or glass supports, etc.

## Claims

1. High efficiency photovoltaic converter for high luminous intensities manufactured using optoelectronic technology **characterized** because a) its semiconductor layers are made of III-V compounds, b) photolithography is used for the definition of the numerous photovoltaic converters on the same semiconductor wafer, as well as for the shape of the front metal grid of each of them, c) its size is in the range of tenths to tens of square millimeters, and d) the separation of the converters on the same semiconductor wafer is carried out by sawing or by cutting with a point or cleaving or other similar techniques.

2. High efficiency photovoltaic converter for high luminous intensities manufactured using optoelectronic technology according to claim 1 **characterized** because the substrate could be a III-V semiconductor or any other type of semiconductor such as germanium or silicon or even a non-semiconductor substrate such as ceramic, glass or similar support.

3.  High efficiency photovoltaic converter for high luminous intensities manufactured using optoelectronic technology according to claims I and 2 **characterized** because it transforms a cone of incident light into electrical energy, with a spectrum corresponding to each particular case and coming from a medium with any refraction index.

4.  High efficiency photovoltaic converter for high luminous intensities manufactured using optoelectronic technology according to claims 1 to 3 **characterized** for its use in photovoltaic solar energy applications, for which the particular spectrum comes from the sun and in which the converter is assembled to an optical concentrator which increases the luminous intensity coming from the sun.

5.  High efficiency photovoltaic converter for high luminous intensities manufactured using optoelectronic technology according to claims 1 to 4 **characterized** because the photovoltaic converter is assembled to an optical concentrator by means of silicone rubber, epoxy, resins or something similar.

6.  High efficiency photovoltaic converter for high luminous intensities manufactured using optoelectronic technology according to claims 1 to 3 **characterized** for producing electrical energy from heat sources (stoves and the like) and whose particular spectrum is, mainly, infrared.

7.  High efficiency photovoltaic converter for high luminous intensities manufactured using optoelectronic technology according to claims 1, 2, 3 and 6 **characterized** because the photovoltaic converter is assembled to an optical concentrator by means of silicone rubbers, epoxies, resins or something similar.

8.  High efficiency photovoltaic converter for high luminous intensities manufactured using optoelectronic technology according to claims 1 to 3 **characterized by** carrying out the conversion of light channeled by optical fiber and coming from a laser into electricity for high-risk environments such as the powering of sensors and electronics in applications such as mines, high-tension grids, the chemical and petrochemical industries, nuclear power plants, airplanes, rockets, satellites, biomedicine, etc.

9.  High efficiency photovoltaic converter for high luminous intensities manufactured using optoelectronic technology according to claims 1 to 5 **characterized** because its encapsulation is carried out by means of optoelectronic techniques such as: a) fixing the converter by means of its rear contact to a support using epoxy or solder, and b) connection of the front contact by means of wire bonding, pick and place, flip-chip, multichip-module or something similar.

10. High efficiency photovoltaic converter for high luminous intensities manufactured using optoelectronic technology according to claims 1 to 4; or 1 to 5; or 1 to 5 and 9 **characterized** because it consists of a single semiconductor junction.

11. High efficiency photovoltaic converter for high luminous intensities manufactured using optoelectronic technology according to claims 1 to 4; or 1 to 5; or 1 to 5 and 9 **characterized** because it consists of several semiconductor junctions.

12. High efficiency photovoltaic converter for high luminous intensities manufactured using optoelectronic technology according to claims 1 to 3 and 6 **characterized** for possessing a monolithic connection in series in order to increase the output voltage.

13. High efficiency photovoltaic converter for high luminous intensities manufactured using optoelectronic technology according to claims 1 to 3 and 6 **characterized** because it consists of a single semiconductor junction.

14. High efficiency photovoltaic converter for high luminous intensities manufactured using optoelectronic technology according to claims 1 to 3 and 6 **characterized** because it consists of several semiconductor junctions.

15. High efficiency photovoltaic converter for high luminous intensities manufactured using optoelectronic technology according to claims 1 to 3 and 8 **characterized** for possessing a monolithic connection in series in order to increase the output voltage

16. High efficiency photovoltaic converter for high luminous intensities manufactured using optoelectronic technology according to claims 1, 2, 3, 6 and 7 **characterized** because its encapsulation is carried out by means of optoelectronic techniques such as: a) fixing the converter by means of its rear contact to a support using epoxy or solder, and b) connection of the frontal contact by means of wire bonding, pick and place, flip-chip, multichip-module or something similar.

**17.** High efficiency photovoltaic converter for high luminous intensities manufactured using optoelectronic technology according to claims 1 to 16 **characterized** because the design parameters (semiconductor structure of III-V compounds, ohmic contacts, geometry, metal grid and antireflection layers) are calculated by means of a multivariable optimization.

**Amended claims under Art. 19.1 PCT**

**1.** (Modified) High efficiency photovoltaic converter for high luminous intensities manufactured using optoelectronic technology **characterized** because a) its semiconductor layers are made of III-V compounds, b) it works at luminous power densities greater than 1 W/cm$^2$, c) its size is in the range of tenths to tens of square millimeters, d) as a result of its reduced size photolithography is used for the definition of the numerous photovoltaic converters on the same semiconductor wafer, as well as for the shape of the frontal grid of each of them, and finally, e) the separation of the converters on the same semiconductor wafer is carried out by sawing or by cutting with a point or cleaving or other similar techniques.

**2.** High efficiency photovoltaic converter for high luminous intensities manufactured using optoelectronic technology according to claim 1 **characterized** because the substrate could be a III-V semiconductor or any other type of semiconductor such as germanium or silicon or even a non-semiconductor substrate such as ceramic, glass or similar support.

**3.** High efficiency photovoltaic converter for high luminous intensities manufactured using optoelectronic technology according to claims 1 and 2 **characterized** because it transforms a cone of incident light into electrical energy, with a spectrum corresponding to each particular case and coming from a medium with any refraction index.

**4.** High efficiency photovoltaic converter for high luminous intensities manufactured using optoelectronic technology according to claims 1 to 3 **characterized** for its use in photovoltaic solar energy applications, for which the particular spectrum comes from the sun and in which the converter is assembled to an optical concentrator which increases the luminous intensity coming from the sun.

**5.** High efficiency photovoltaic converter for high luminous intensities manufactured using optoelectronic technology according to claims 1 to 4 **characterized** because the photovoltaic converter is assembled to an optical concentrator by means of silicone rubber, epoxy, resins or something similar.

Fig. 1

## INTERNATIONAL SEARCH REPORT

| International application No. |
|---|
| PCT/ES01/00167 |

**A. CLASSIFICATION OF SUBJECT MATTER**

**IPC7** H 01 L 31/04, 31/042, 31/052, 31/0328, 31/0352

According to International Patent Classification (IPC) or to both national classification and IPC

**B. FIELDS SEARCHED**

Minimum documentation searched (classification system followed by classification symbols)

**IPC7** H 01 L

Documentation searched other than minimum documentation to the extent that such documents are included in the fields searched

Electronic data base consulted during the international search (name of data base and, where practicable, search terms used)

EPODOC, WIPL, PAJ, CIBEPAT

**C. DOCUMENTS CONSIDERED TO BE RELEVANT**

| Category* | Citation of document, with indication, where appropriate, of the relevant passages | Relevant to claim No |
|---|---|---|
| Y | JP 09-232609 A (NIPPON TELEGR & TELEPH CORP) 05.09.1997 (resumen) World Patents Index [en línea]. Londres (Reino Unido): Derwent Publications, Ltd. [recuperado el 18.07.2001]. Recuperado de: Questel/Orbit, París (Francia). DW 9746, N° de acceso 97-495996 | 1-4, 6, 10-14 |
| Y<br>A | US 5652436 A (STONER, B. et al.) 29.07.1997, Column 2, line 39-column 4, line 3; column 4, lines 30-44; column 5, line 56-column 6, line 17; column 7, lines 45-63; column 8, line 52-column 9, line 10; figures. | 1-4, 6, 10-14<br>5, 7-8, 15-16 |
| Y<br>A | JP 03-076164 A (ASAHI GLASS CO LTD) 02.04.1991 (abstract) World Patents Index [en línea]. Londres (Reino Unido): Derwent Publications, Ltd. [recuperado de: Questel/Orbit, París (Francia). DW 9119, N° de acceso 91-137606 | 1<br>2-4, 6, 10-14 |
| Y<br>A | JP 05-343721 A (HITACHI LTD) 24.12.1993 (abstract) World Patents Index [en línea]. Londres (Reino Unido): Derwent Publications, Ltd. [recuperado el 20.07.2001]. Recuperado de: Questel/Orbit, París (Francia). DW 9405, N° de acceso 94-038673 | 1<br>2-4, 6, 10-14 |

☐ Further documents are listed in the continuation of Box C.　　☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 07 August 2001 (07.08.01) | 10 August 2001 (10.08.01) |

| Name and mailing address of the ISA/ | Authorized officer |
|---|---|
| S.P.T.O. | |
| Facsimile No. | Telephone No. |

Form PCT/ISA/210 (second sheet) (July 1992)

# EP 1 278 248 A1

## INTERNATIONAL SEARCH REPORT
Information on patent family members

International Application No

PCT/ES01/00167

| Patent document cited in search report | Publication date | Patent familiy member(s) | Publication date |
|---|---|---|---|
| JP 09-232609 A | 05.09.1997 | NONE | |
| US 5652436 A | 29.07.1997 | NONE | |
| JP 03-076164 A | 02.04.1991 | NONE | |
| JP 05-343721 A | 24.12.1993 | NONE | |

Form PCT/ISA/210 (patent family annex) (July 1992)

11